Europäisches Patentamt

European Patent Office

Office européen des brevets

(11) Publication number: **0 675 371 A2**

## EUROPEAN PATENT APPLICATION

(21) Application number: **95104838.8**

(22) Date of filing: **31.03.95**

(51) Int. Cl.6: **G01R 33/09**, G11B 5/39

(30) Priority: **31.03.94 JP 63364/94**

(43) Date of publication of application:
**04.10.95 Bulletin 95/40**

(84) Designated Contracting States:
**DE FR GB**

(71) Applicant: **YAMAHA CORPORATION**
**10-1, Nakazawa-cho**
**Hamamatsu-shi**
**Shizuoka-ken (JP)**

(72) Inventor: **Shiraki, Makoto, c/o Yamaha**
**Corporation**
**10-1, Nakazawa-cho**
**Hamamatsu-shi,**
**Shizuoka (JP)**
Inventor: **Endo, Hiroshi, c/o Yamaha**
**Corporation**
**10-1, Nakazawa-cho**

**Hamamatsu-shi,**
**Shizuoka (JP)**
Inventor: **Oohashi, Toshiyuki, c/o Yamaha**
**Corporation**
**10-1, Nakazawa-cho**
**Hamamatsu-shi,**
**Shizuoka (JP)**
Inventor: **Horiai, Naoshi, c/o Yamaha**
**Corporation**
**10-1, Nakazawa-cho**
**Hamamatsu-shi,**
**Shizuoka (JP)**

(74) Representative: **Geyer, Ulrich F., Dr.**
**Dipl.-Phys. et al**
**WAGNER & GEYER,**
**Patentanwälte,**
**Gewürzmühlstrasse 5**
**D-80538 München (DE)**

(54) **Magnetic head having magnetoresistive sensor.**

(57) An MR element is made of an isotropic magnetoresistive material film. A ratio (H/W) of an element height H to an element width W of the MR element is set to 0.8 or more. A width $W_E$ of lead electrodes connected to the element, in a element height direction, is set smaller than the element height. At least part of an end portion of the MR element on the head front end side facing to a magnetic recording medium is not covered with the lead electrodes. A magnetoresistive thin film magnetic head which has a high magnetic field sensitivity and a large reproduction output is provided.

FIG.3

FIG.4

EP 0 675 371 A2

BACKGROUND OF THE INVENTION

a) Field of the Invention

The present invention relates to a magnetoresistance thin film magnetic head having a magnetoresistive sensor element (hereinafter called an MR sensor element).

b) Description of the Related Art

A magnetoresistive (MR) sensor element detects magnetic field signals through the resistance changes of a read element made of a magnetic material as a function of the amount and direction of magnetic flux being sensed by the element.

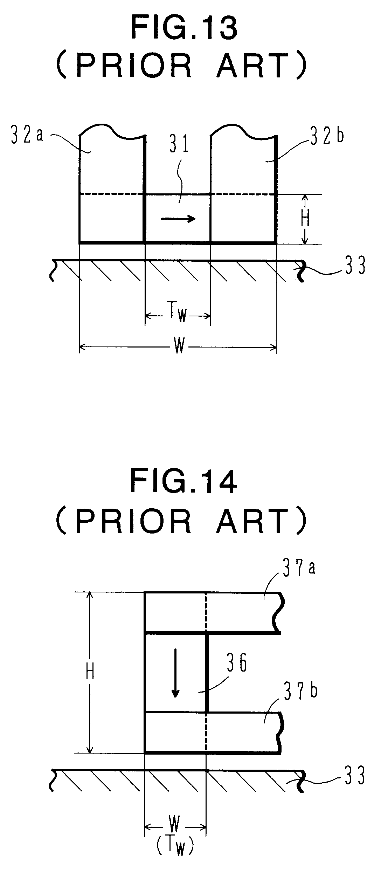

Fig.12 is a schematic perspective view showing an example of a conventional magnetoresistance thin film magnetic head (of a piggy-back type). A shield film 25 is formed on a substrate 28. An MR film 26 is formed on the surface of the shield film 25 at a region on the head front end side, with the longitudinal direction of the MR film 26 being in parallel with the plane of the head front end. A pair of lead electrodes 27 is connected to both the end portions of the MR film 26 in its longitudinal direction, and extends over the shield film 25 in the direction perpendicular to the longitudinal direction of the MR film 26. Another shield film 24 is formed over the MR film 26 and the lead electrodes 27. Cores 22 and 23 are stacked one upon the other with a gap on the shield film 24. A coil 21 is formed between these cores 22 and 23. The ends of the cores 22 and 23 on the head front end side are spaced apart by a predetermined distance, and the other ends thereof are connected together at the central area of the coil 21.

In operation of the magnetoresistance thin film magnetic head, a signal is supplied to the coil 21 to record data. Data reproduction is performed by detecting a change in a resistance value of the MR film 26 produced by a change in magnetic fluxes generated from a recording medium. An output of the MR film 26 depends on a magnetic field intensity and does not depend on a relative speed of the head and a magnetic recording medium. As a result, it has an advantage that a reproduction output does not lower even at a slow relative speed.

Of conventional magnetoresistance thin film magnetic heads, an MR film 31 is disposed with its longitudinal direction being set generally in parallel to the surface of a recording medium 33 as shown in Fig.13, or an MR film 36 is disposed with its longitudinal direction being set generally perpendicular to the surface of a magnetic recording medium 33 as shown in Fig.14. The length of an MR film in a direction parallel to the surface of the recording medium is called an element width W, and the length in a direction perpendicular to the surface of the recording medium is called an element height H. In the magnetoresistance thin film magnetic head shown in Fig.13, lead electrodes 32a and 32b are connected to both the ends of the MR film 31 in its longitudinal (width) direction, and extend generally perpendicularly to the surface of the recording medium 33. A portion of the MR film 31 between the lead electrodes 32a and 32b becomes an active region. Similarly, in the magnetoresistance thin film magnetic head shown in Fig.14, lead electrodes 37a and 37b are connected to both the ends of the MR film 36 in its longitudinal (height) direction, and extend generally in parallel to the surface of the recording medium 33. A portion of the MR film 36 between the lead electrodes 37a and 37b becomes an active region.

An aluminum oxide ($Al_2O_3$) film as a passivation film is usually formed on the front end of an MR thin film magnetic head. Therefore, the MR thin film magnetic head should be positioned remote from the surface of a recording medium at least by the amount corresponding to the thickness of the passivation film. Recent progress in high density recording has made a track width Tw as small as about 3 $\mu$m or less. An element height H as small as about 5 $\mu$m or less is also realized. The element height H of the MR film 31 of the magnetoresistance thin film magnetic head shown in Fig.13 is small so that a change in magnetic field applied to the MR film 31 can easily induce a demagnetization field and the magnetic field sensitivity is lowered by the demagnetization field. This magnetic field sensitivity does not become sufficient even if granular type magnetic material is used instead of generally applied MR material (Permalloy™). The element height H of the magnetoresistance thin film magnetic head shown in Fig.14 is large and the element width W is the same as the track width Tw. Although the magnetic field sensitivity is hardly lowered, a reproduction output is lowered because the MR film portion connected to the lead electrodes does not contribute to magnetic field detection and the active region is positioned further remote from the recording medium 33 by an amount corresponding to the height of the lower lead electrode 37b.

## SUMMARY OF THE INVENTION

An object of the present invention is to provide a magnetoresistive thin film magnetic head with a high magnetic field sensitivity and a large reproduction output.

According to one aspect of the present invention, there is provided a magnetoresistive thin film magnetic head including: a magnetoresistive film element made of isotropic magnetoresistive material and having a ratio (H/W) of an element height (H) to an element width (W) set to 0.8 or more; and a pair of lead electrodes connected to the magnetoresistive film element and having a length ($W_E$) in the element height direction smaller than element height (H) ($W_E < H$); wherein part of an end portion of the magnetoresistive film element on the head front end side designed to face to a magnetic recording medium is not covered with the pair of the lead electrodes.

The "element width" is a width of a region of the magnetoresistive film element, which region is capable of reducing a demagnetization field.

## BRIEF DESCRIPTION OF THE DRAWINGS

Figs.1 and 2 are schematic plan and bottom views of a magnetoresistance thin film magnetic head according to a first embodiment of the invention.

Fig.3 is a schematic plan view illustrating the relationship between an element height H and an element width W of the MR element shown in Figs.1 and 2.

Fig.4 is a circuit diagram of a reproduction signal amplifier.

Fig.5 is a graph showing the relationship between a head output and a ratio (H/W) of an element height H to an element width W.

Figs.6A, 6B, and 6C are a horizontal cross sectional view, a side plan view, and a vertical longitudinal cross sectional view of an example of the structure of the magnetic head of the first embodiment.

Figs.7 and 8 are schematic cross sectional views of other structure of MR element.

Fig.9A and 9B are a schematic side plan view and aschematic bottom view of a magnetoresistance thin film magnetic head according to a second embodiment of the invention.

Figs.10A, 10B, and 10C are a schematic side plan view of a magnetoresistance thin film magnetic head and schematic side plan and bottom views of the MR element, according to a third embodiment of the invention.

Fig.11 is a schematic side plan view of a magnetoresistance thin film magnetic head according to a fourth embodiment of the invention.

Fig.12 is a schematic perspective view of an example of a conventional magnetoresistance thin film magnetic head (of a piggy-back type).

Fig.13 is a schematic side plan view of an MR element of the conventional magnetoresistance thin film magnetic head.

Fig.14 is a schematic plan view of another MR element of the conventional magnetoresistance thin film magnetic head.

## DETAILED DESCRIPTION OF THE PREFERRED EMBODIMENTS

In the present specification, a width direction (first direction) means a direction substantially parallel to a plane of a magnetic recording medium and parallel to a plane of a substrate on which plane of the substrate a magnetic head structure is to be formed. Also, a height direction (second direction) means a direction substantially perpendicular to the plane of the magnetic recording medium and parallel to the plane of the substrate. The term "substantially" is used to cover a slight angle offset due to inclination of the floating magnetic head relative to the magnetic recording medium.

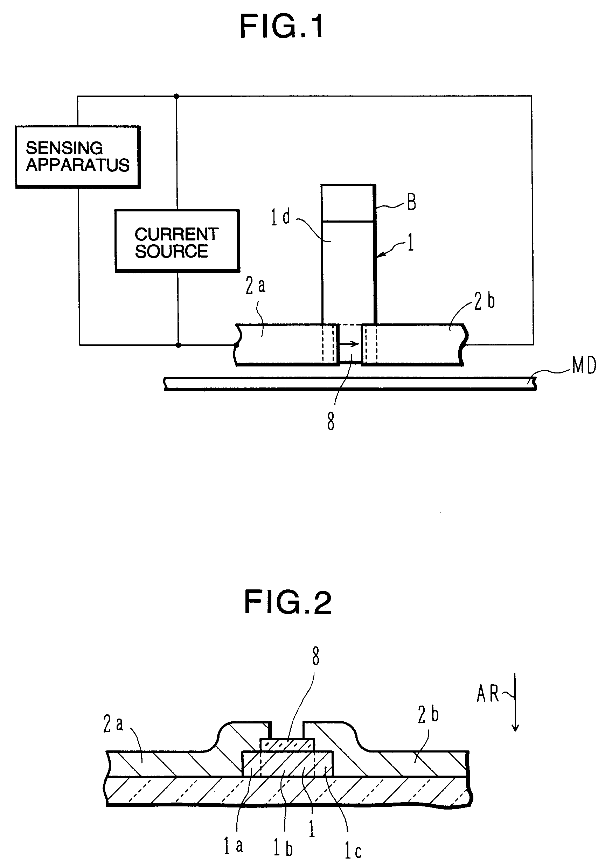

Fig.1 is a schematic plan view of a magnetoresistance thin film magnetic head as viewed in a plane defined by an axis along the width direction and an axis along the height direction, according to the first embodiment of the invention, and Fig.2 is a schematic bottom view showing the MR head of the first embodiment as viewed in a plane facing a magnetic recording medium. In this embodiment, an MR layer 1 has its height direction, which is the longitudinal direction, disposed substantially perpendicular to the plane of magnetic recording medium, i.e. perpendicular to the head front end plane facing the plane of a magnetic recording medium.

An insulating passivation film 8 is formed on the MR layer 1 as seen in Fig.2. This insulating film 8 is made of, for example, $Al_2O_3$. A region of the MR layer 1 on which the insulating film 8 is formed and current flows therethrough, is physically and electrically isolated from a pair of lead electrodes 2a and 2b.

This region 1b is called an active region 1b. A change in an external magnetic field is detected by a change in the resistance of the active region 1b. Regions of the MR layer 1 on which the insulating film 8 is not formed, i.e., passive regions 1a and 1c, also change their resistance values with an external magnetic field. These regions, however, are contacted with the lead electrodes 2a and 2b and do not contribute to detecting an external magnetic field. In this embodiment, the MR layer 1 has a back region 1d, as shown in Fig.1, not connected to the lead electrodes 2a and 2b and extending from the positions of the upper ends of the lead electrodes in the height direction toward the direction opposite to a recording medium MD.

As seen from Fig.1 and 2, the lead electrodes 2a and 2b extend in anti-parallel directions generally in parallel to the plane of the magnetic disc MD, from the spaced positions on both the end portions of the MR layer 1 on the head front end side.

In this embodiment, the MR layer 1 extends upward in Fig.1 from the active region 1b between the confronting lead electrodes 2a and 2b. A bias layer B is formed adjacent to the upper end of the MR layer 1 in the height direction. A bias layer B applies a bias magnetic field which determines an operating point so that the resistance value of the MR layer 1 linearly changes with an external magnetic field.

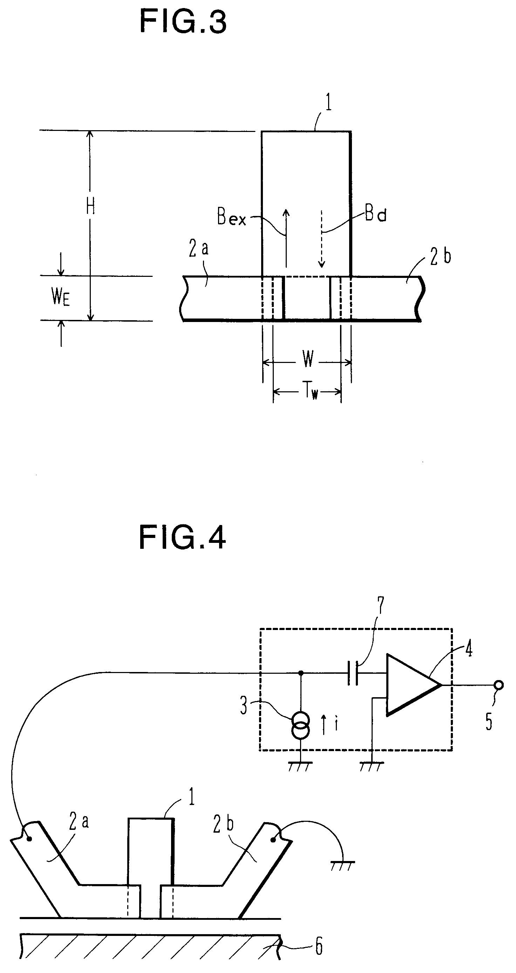

As will be later described with Fig.4, the electrodes 2a and 2b are connected to a current source for supplying current to the MR layer 1 and to a sensing means connected in parallel to the current source for detecting a change in a resistance value of the MR layer 1.

The MR film 1 is made of isotropic magnetoresistive material such as granular type material. The granular type magnetoresistive material is defined as the material in which ferromagnetic particles are uniformly dispersed in a bulk of a conductive and non-magnetic material. As shown in Fig.3, the height H of the MR layer 1 of this embodiment is set sufficiently larger than the width W (H/W $\geq$ 2). The width $W_E$ ofthe lead electrode in the height direction is set sufficiently smaller than the height H ($W_E$ < H) in order to increase the resistance value of the MR layer 1. Direction of current flow changes widely in the MR layer 1.

Examples of granular type material which contains ferromagnetic material mixed in conducting and non-magnetic material are given in the following.

(a) ferromagnetic material: FeCo alloy
conductive and non-magnetic material: Ag
(b) ferromagnetic material: FeCo alloy
conductive and non-magnetic material: AgCu alloy
(c) ferromagnetic material: Fe or Fe alloy
conductive and non-magnetic material: Ag
(d) ferromagnetic material: Co or Co alloy
conductive and non-magnetic material: Ag
(e) ferromagnetic material: Fe or Fe alloy
conductive and non-magnetic material: Cu
(f) ferromagnetic material: Co or Co alloy
conductive and non-magnetic material: Cu
(g) ferromagnetic material: FeCo alloy
conductive and non-magnetic material: Cu

The granular magnetoresistive material according to the above (a) type is composed of an alloy having an atomic composition which is expressed by a following chemical formula.

$$(Co_{1-x}Fe_x)_yAg_{1-y} \qquad (1)$$

where 0.45 $\leq$ x $\leq$ 0.55 and 0.24 $\leq$ y $\leq$ 0.35.

In the above chemical formula (1), if the value of "y" is less than 0.24 (i.e., y < 0.24), or if the value of "y" is greater than 0.35 (i.e., y > 0.35), the magnetic-field sensitivity (dMR/dH) is less than 0.05 (%/Oe). In the present specification, the magnetic-field sensitivity is defined as the change of resistance in the percentage per unit magnetic field Oe (in Oersted). If the value of "x" is less than 0.45 (i.e., x < 0.45), or greater than 0.55 (i.e., x > 0.55), it is difficult to increase the value of the magnetic-field sensitivity to be greater than 0.05 (%/Oe). In order to utilize the magnetoresistive material for the sensor using the MR effect, the magnetic-field sensitivity of the magnetoresistive material should be equal to or greater than 0.05 (%/Oe). For this reason, the value of "x" used in the chemical formula (1) is limited to the range of "0.45 $\leq$ x $\leq$ 0.55", while the value of "y" is limited to the range of "0.24 $\leq$ y $\leq$ 0.35".

Copper (Cu) may also be included up to the solubility limit of Cu in the matrix of Ag (i.e., 14 atomic-percentage), as listed in the above (b) type;

$$(Co_{1-x}Fe_x)_y(Ag_{1-z}Cu_z)_{1-y} \qquad (2)$$

where $0.45 \leq x \leq 0.55$, $0.24 \leq y \leq 0.35$, and $z \leq 0.14$. The magnetoresistive material, as expressed by the aforementioned chemical formula (1), may not be substantially changed in magnetic-field sensitivity by the addition of Cu. Therefore, another atomic composition, as expressed by the chemical formula (2), can be employed for the alloy realizing the magnetoresistive material. The alloy as expressed by the chemical formula (2) can offer a good magnetic-field sensitivity, similar to the alloy of the chemical formula (1).

Further details may be found in a US patent application, Serial NO. 08/297,222 filed on August 29, 1994 (Oohashi et al), which is incorporated herein by reference.

Isotropic magnetoresistive material (IMR) means a material which shows resistance changes in accordance mainly with spin-dependent electrons scattering depending on statuses of magnetic spins in the MR material. IMR changes its resistance values depending solely upon magnitude of a magnetic field and its resistance change is regardless of the direction of a current flow. In this respect IMR is isotropic. On the contrary, an anisotropic magnetoresistive material (AMR), such as NiFe alloy (Permalloy™), shows resistance changes in accordance with the angle made between a direction of a magnetization of the element and a direction of a current flow. Therefore, AMR anisotropically changes its resistance value with respect to a direction of a current flow.

Therefore, if isotropic magnetoresistive material (IMR) is used, the direction of a sense current flow can be set as desired. Examples of isotropic magnetoresistive material are granular type material, artificial lattice type material, and spin valve type material (refer to "Progress in Magnetoresistive Material & Particle Dispersed Type Magnetoresistive Material" by Kitada in the January edition of "Metal", 1994, which is herein incorporated by reference).

If an MR element made of isotropic magnetoresistive material is used, the shape of an MR film and the positions of lead electrodes can be set freely. It is therefore possible to set the length $W_E$ of the lead electrodes in the element height direction smaller than the height H of the MR film ($W_E < H$) and to configure at least part of an end portion of the magnetoresistive film on the head front end side (on the magnetic recording medium side) not to be covered with the pair of the lead electrodes. Accordingly, the active region of the MR element can be positioned near to the recording medium. If such a magnetoresistance thin film magnetic head is formed by using an MR element made of anisotropic magnetoresistive material such as Permalloy™, the magnetoresistance of anisotropic magnetoresistive material changes with an angle between a direction of an external magnetic field and a direction of a sense current flow. Therefore, a bias field for stabilizing magnetic domains is required and the head structure becomes complicated.

In this embodiment, since the MR layer 1 has its height direction corresponding to the longitudinal direction disposed substantially perpendicular to the surface of the magnetic recording medium, i.e. perpendicular to the plane of the head front end, a demagnetization field is small and the magnetic field sensitivity (dMR/dH) is high.

The MR layer 1 is used for reading data magnetically written in a magnetic recording medium MD. In reading data, the whole width (passive regions 1a and 1c and active region 1b) of the MR layer 1 guides magnetic fluxes written in the recording medium MD, because of low magnetic reluctance. The MR layer of this embodiment has the back region 1d at the back of the lead electrodes 2a and 2b. As illustrated in Fig.3, the back region 1d functions to reduce a demagnetization field Bd which cancels an external magnetic field Bex. As a result, even if a track width is narrowed in order to increase a record density, it is possible to suppress the demagnetization field which lowers the magnetoresistive effects of the MR layer 1.

In this embodiment, the active region between the lead electrodes 2a and 2b is positioned on the side of a recording medium and the distance between the recording medium and the active region is short, so that the field intensity is high and a large reproduction output can be obtained.

An MR film made of isotropic magnetoresistive material is used for a magnetoresistive element (MR element). At least part of an end portion of the MR film on the head front end side (magnetic recording medium side) is not covered with a pair of lead electrodes, and the height of the MR film in the direction perpendicular to the plane of the head front end is set greater than the height of the lead electrodes. In this manner, the magnetic field sensitivity is prevented from being lowered by a demagnetization field and a reproduction output is increased.

Magnetoresistance thin film magnetic heads of this embodiment were manufactured and the operation characteristics thereof were checked. Magnetoresistance thin film magnetic heads with the MR layer such as shown in Figs.1 to 3 were manufactured. Granular type CoFeAg alloy was used as the material of the MR layer 1. The whole element width W was 10 $\mu$m, the width of the active region 1b between electrodes 2a and 2b (track width Tw) was 5 $\mu$m, the thickness of the MR layer was 500 angstroms, and the width $W_E$ of the lead electrodes was 3 $\mu$m. The element height H was set in a range of 3 to 50 $\mu$m. A head output (V) was measured under the following conditions shown in Table 1.

Table 1

| Magnetic disc | 2.5 inch disc<br>Coercive force: 1600 (Oe)<br>Residual Magnetic<br>flux density Br$\delta$ 300 G-$\mu$m |
|---|---|
| Magnetic head | Write coil: 20 turns<br>Record track width: 10 $\mu$m<br>MR layer track width: 5 $\mu$m<br>Sense current: 10 mA |
| Record/reproduction condition | Circumferential<br>speed: 5 m/sec with floating height of 0.1 $\mu$m<br>Record frequency: 5 MHz |

A signal of the MR element was amplified by a reproduction signal amplifier such as shown in Fig.4. In this reproduction signal amplifier, a sense current i is supplied from a constant current source 3 to the MR element via the lead electrodes 2a and 2b, a resistance change produced by magnetic fluxes of a recording medium (magnetic disc) 6 is transformed into a voltage change by the sense current, is taken out through a capacitor 7, and amplified by an amplifier 4 to pick up an output signal from a terminal 5.

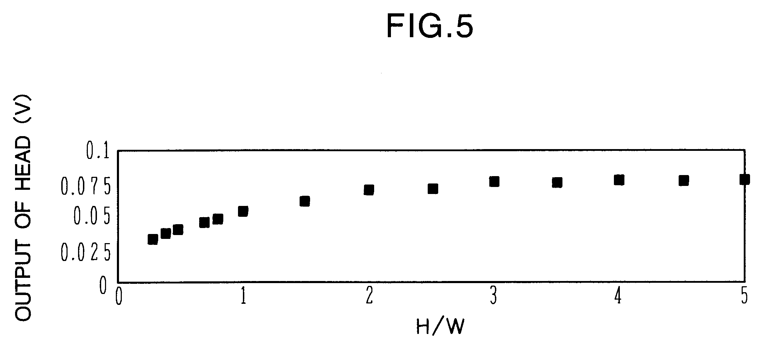

Head outputs (V) at various ratios (H/W) of an element height to an element width, which ratio is set by various element heights H, are given in Table 2 and Fig.5.

Table 2

| Element height H ($\mu$m) | Ratio of element height to element width H/W | Head output (V) |
|---|---|---|
| 3 | 0.3 | 0.035 |
| 4 | 0.4 | 0.039 |
| 5 | 0.5 | 0.042 |
| 7 | 0.7 | 0.048 |
| 8 | 0.8 | 0.05 |
| 10 | 1 | 0.055 |
| 15 | 1.5 | 0.063 |
| 20 | 2 | 0.071 |
| 25 | 2.5 | 0.073 |
| 30 | 3 | 0.077 |
| 35 | 3.5 | 0.077 |
| 40 | 4 | 0.078 |
| 45 | 4.5 | 0.078 |
| 50 | 5 | 0.079 |

As seen from Table 2 and Fig.5, a very good sensitivity with an head output of 0.05 V or higher can be obtained if the ratio (H/W) of the element height H to the element width W is set to 0.8 or more.

A ratio (H/W) of an element height H to an element width (W) of an MR film is set to 0.8 or more. If this ratio (H/W) is smaller than 0.8, an influence of a demagnetization field becomes large and the magnetic field sensitivity lowers. It is therefore desired to set the ratio (H/W) to 0.8 or more. With this setting, the magnetic field sensitivity (dMR/dH) can be set to 0.05 %/Oe or higher, allowing to detect a weak magnetic field. The ratio (H/W) of the element height H to the element width W is preferably set to 1.0 or more, or more preferably it is set to 2.0 or more.

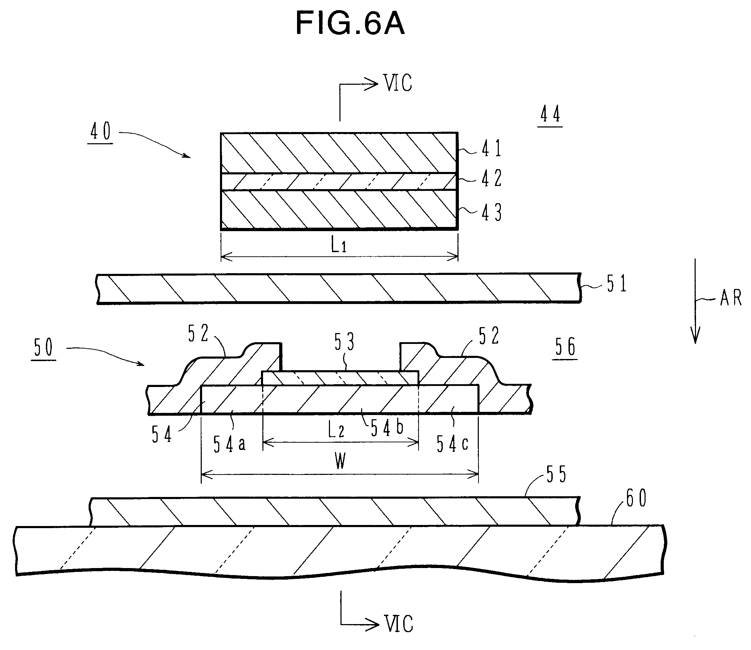

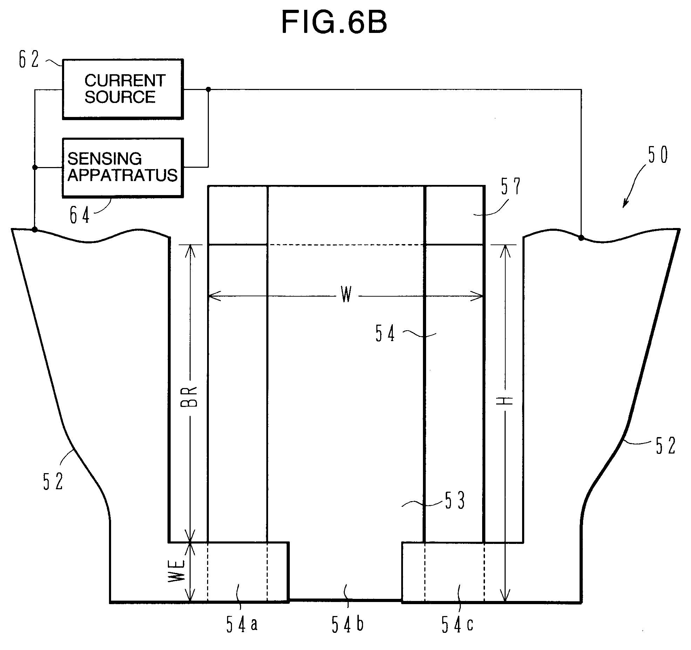

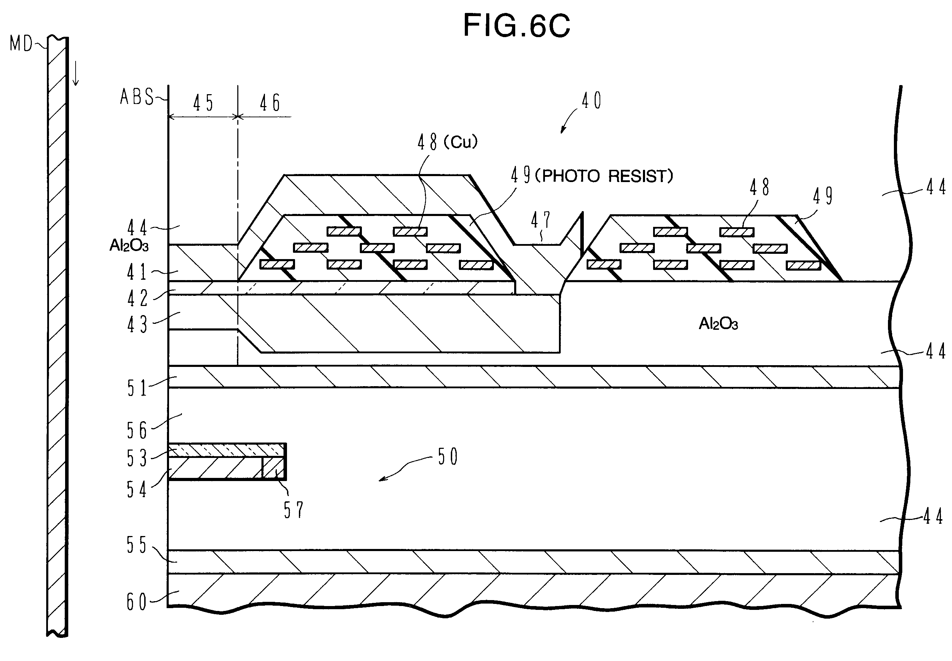

Next, a composite thin film magnetic head incorporating an MR head having the structure of the first embodiment will be described. Fig.6A is a cross sectional view showing the composite thin film magnetic head at the peripheral portion near the front end of the head, as viewed from the side of a magnetic recording medium. Fig.6B is a partially broken side plan view seen from a direction parallel to the motion of

6

a recording disk, showing a read transducer 50 of the composite thin film magnetic head. Fig.6C is a cross sectional view of the composite thin film magnetic head taken along line VIC-VIC of Fig.6A.

As shown in Fig.6A, the composite thin film magnetic head includes a write transducer 40 having an inductive magnetic head and the read transducer 50 having an MR head. The write and read transducers 40 and 50 are magnetically isolated by a magnetic shield 51. The read transducer 50 is formed on a magnetic shield 55 which is formed on a substrate 60. The substrate 60 is made of, for example, glass, ceramics such as $Al_2O_3$-TiC, and semiconductor.

As shown in detail in Fig.6C, the write transducer 40 includes a lower magnetic layer 43 (lower core) formed in an insulating layer 44 made of, for example, $Al_2O_3$, a magnetic gap layer 42 made of insulating and non-magnetic material and formed on the lower core 43, a conductive layer 48 and an insulating layer 49 formed above the magnetic gap layer 42, and an upper magnetic layer 41 (upper core) formed on the insulating layer 49. A passivation film 44 made of insulating alumina is formed on the upper cores 41. The upper and lower cores 41 and 43 are made of NiFe alloy (Permalloy™). The magnetic gap layer 42 is made of an insulating film such as $Al_2O_3$ and $SiO_2$. The conductive layer 48 is made of conductive material such as Cu, and forms a coil of an ellipsoidal shape (similar to Fig.12). The insulating layer 49 is made of photoresist.

The upper and lower cores 41 and 43 are stacked one upon the other with the insulating and non-magnetic layer 42 being interposed therebetween at a pole region 45, and physically and magnetically connected (back gap closure) at a through hole 47 in a back region 46.

Magnetic fluxes induced by current flowing through the conductive layer 48 are guided by the upper and lower cores 41 and 43 to the pole region 45. The magnetic fluxes in the upper and lower cores 41 and 43 cannot flow smoothly through the magnetic gap layer 42 between the cores at the pole region 45, and leak out to the external space from an air bearing surface ABS at the pole region. This leak magnetic fluxes record data in a magnetic recording medium. As shown in Fig.6A, a length L1 of the upper and lower cores 41 and 43 of the writing transducer 40 in the width direction determines a track width.

The read transducer 50 includes a lower magnetic shield 55 formed on the substrate 60, an insulating film 56 formed on the lower magnetic shield 55, an MR layer 54 formed in the insulating film 56, an insulating passivation film 53 formed on the MR layer 54 except the both side regions, lead electrodes 52 (Fig.6A) for being electrically connected to the MR layer 54 at the lower end portion (Fig.6B), and an upper magnetic shield 51 planarized on the insulating film 56. The read transducer 50 has, as shown in Fig.6B, an operating point bias layer 57 formed adjacent to the upper end portion of the MR layer 54 on the side opposite to the lower front end of the MR layer 54 facing the recording medium MD. The operating point bias layer 57 formed at this position prevents the magnetic field generated by the operating point bias layer 57 from interfering data read from the recording medium MD.

In this embodiment, a back region BR of the MR layer 54 is formed extending in the height direction on the side opposite to the front end of the MR layer 57, the back region BR extending from the upper end of the lead electrodes 52 and not physically connected to the lead electrodes 52 (see Fig.6B). The back region BR also reduces a demagnetization field.

The upper and lower magnetic shields 51 and 55 are made of NiFe alloy (Permalloy™) and magnetically isolate the write transducer 40 from the read transducer 50.

The MR layer 54 is made of, for example, granular type material having the composition described earlier.

The region of the MR layer 54 where the insulating passivation film 53 made of, for example, $Al_2O_3$ or $SiO_2$ is formed, is physically and electrically isolated from the lead electrodes 52. This region 54b, which is covered by the insulating passivation film 53 and current flows therethrough, is called an active region. A change in an external magnetic field is detected from a change in the resistance of the active region 54b. The regions of the MR layer 54 where the insulating passivation film 53 is not formed and the lead electrodes are electrically connected, constitute passive regions 54a and 54c. Although the resistance value of the passive region changes with an external magnetic field, this resistance change does not contribute to detecting an external magnetic field.

As shown in Fig.6A, the width L2 of the active region 54b of the MR layer 54 in the direction substantially parallel to the plane of a magnetic recording medium and parallel to the plane of the substrate on which plane the head is formed, is smaller than the width L1 in the width direction of the upper and lower cores 41 and 43 of the write transducer 40. Selecting such a width relationship improves a read precision of the read transducer 50. The reason for this is as follows. Although unnecessary turbulent magnetic fluxes generated from the magnetic pole ends are also written in a recording medium MD when the write transducer 40 writes data therein, these unnecessary turbulent magnetic fluxes are mostly not picked up by the read transducer 50 because the width L2 of the active region 54b is set smaller than the width L1 of the write transducer 40. As a result, the performance of the read magnetic head can be improved.

Also in this embodiment, the ratio H/W of the height H of the MR layer 54 in the height direction to the width W in the width direction (total width of the active region 54b and passive regions 54a and 54c) thereof is preferably set to 0.8 or more.

The operating bias layer 57 is made of, for example, a soft magnetic film or a permanent magnet film.

The width of the lead electrode disposed apart from and along the back region BR of the MR layer 54 is broadened to lower the resistance of the lead electrode. The low resistance reduces exothermic energy and lowers the operating temperature of the MR layer.

A current source 62 is connected to the lead electrodes 52 to supply current to the MR layer 54. The MR layer 54 changes its electrical resistance value with an external magnetic field. A sensing apparatus 64 detects a change in the resistance value to detect a change in the external magnetic field.

Examples of granular type (particle dispersed type) material are Ag-FeCo and Ag-Co. No magnetic domain walls are formed in granular type material so that Barkhausen noises by motion of magnetic domains are not generated.

In the above embodiments, granular type material is used for the MR layer. In the next embodiment, other materials are used.

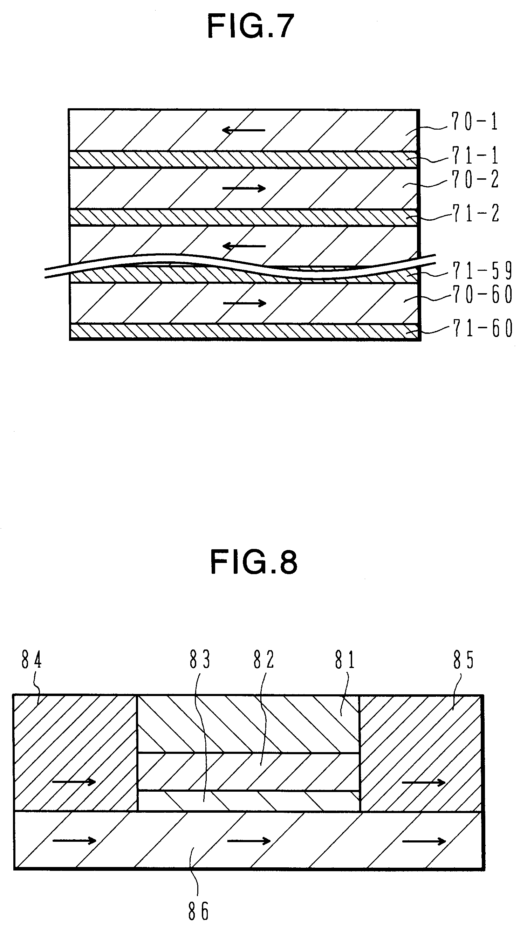

An artificial lattice film (multilayer film) is classified into a coupling type artificial film and a non-coupling type artificial film. An example of the coupling type artificial film is, as shown in Fig.7, a laminate of 60 layers of a Fe film (70-1 to 70-60) having a thickness of 30 angstroms and 60 layers of a Cr film (71-1 to 71-60) having a thickness of 9 angstroms, stacked alternately. The Fe films are antiferromagnetically (anti-parallely) coupled by the non-magnetic Cr film. When magnetization is aligned in the same direction, the resistance changes by about 20 %. This artificial lattice film requires a strong magnetic field of about 10 kOe.

An example of a non-coupling type artificial lattice film is a laminate of 15 layers of a Cu film having a thickness of 50 angstroms, 15 layers of a Co film having a thickness of 30 angstroms, 15 layers of a Cu film having a thickness of 50 angstroms, and 15 layers of an NiFe film having a thickness of 30 angstroms, stacked alternately. The Co film and NiFe film have different coercivities. This artificial lattice film utilizes a resistance change caused by a difference between anti-parallel magnetization and parallel magnetization of the Co film and NiFe film. The NiFe film having a small coercivity changes magnetization direction by a relatively small magnetic field (about 100 Oe), and the resistance changes by about 10 %.

An example of a spin valve film is, as shown in Fig.8, a laminate of a first ferromagnetic material (NiFe) film 86 having a thickness of 100 angstroms, a conductive and non-magnetic material (Cu) film 83 having a thickness of 22 angstroms, a second ferromagnetic material (NiFe) film 82 having a thickness of 47 angstroms, an antiferromagnetic material (FeMn) film 81 having a thickness of 78 angstroms. Magnetization direction of the NiFe film 82 in contact with the antiferromagnetic material (FeMn) film 81 is fixed, whereas magnetization direction of the NiFe film 86 changes. The combination of the NiFe film 82 and NiFe film 86 forms anti-parallel magnetization and parallel magnetization. A transition therebetween generates a change in resistance. The resistance changes by a weak magnetic field (about 10 Oe). Because of a small number of layers, the resistance changes by about 5 %. Magnetization direction of the NiFe film 86 rotates as an external magnetic field changes and becomes anti-parallel to, or parallel to, that of the NiFe film 82. As magnetization direction rotates, current becomes easy or difficult to flow. This electrical current change is used for detecting a change in the external magnetic field.

Longitudinal bias layers 84 and 85 are formed on both side ends of the NiFe film 86 to make the NiFe film 86 have a single magnetic domain to suppress Barkhausen noises.

Also in the case of a film having a multilayer film structure or a spin valve film structure, the ratio H/W of the element height H to the width W (total width of the active region 54b and passive regions 54a and 54c) is preferably set to 0.8 or more.

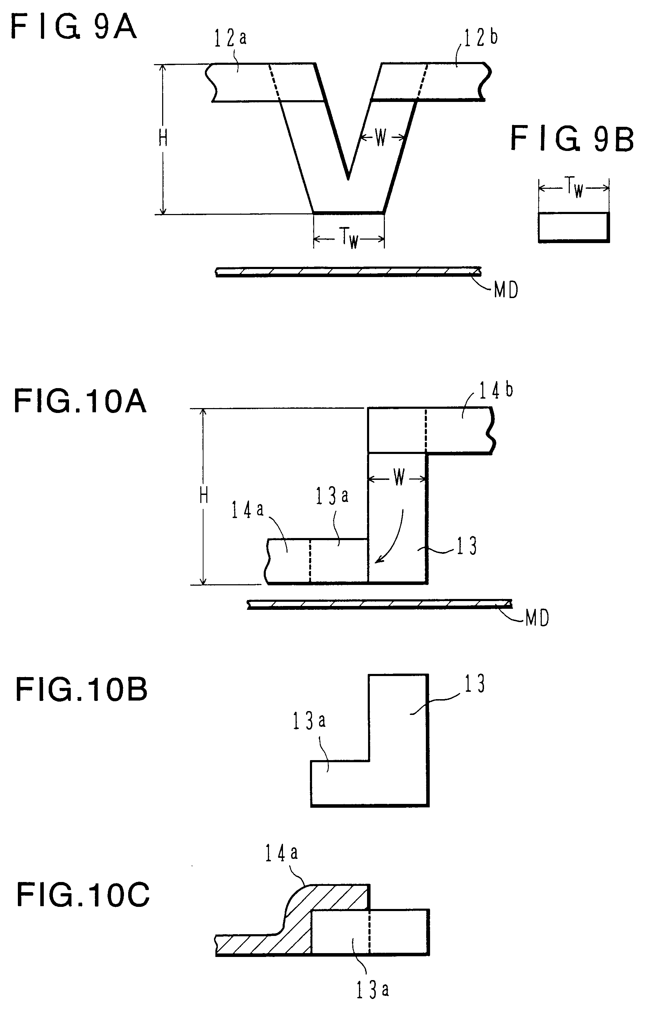

Fig.9A and 9B are a schematic side plan view and a schematic bottom view of a magnetoresistance thin film magnetic head according to another embodiment of the invention. In this embodiment, an MR layer 11 as viewed in a direction parallel to the motion of the magnetic disk MD has a bent shape of V-character. The bent portion of the MR layer 11 is directed toward the head front end, and lead electrodes 12a and 12b are connected to the distal ends of the MR film remote from the head front end. The MR film 11 is made of isotropic magnetoresistive material similar to the above embodiments. The element width W of the MR film is set smaller than the element height (H > W). The width Tw of the bent portion of the MR film 11 becomes the track width Tw.

This embodiment has the same advantageous effects as the previously described embodiments. In addition, the length (current path length) of the MR film 11 can be significantly elongated. It is therefore possible to increase a change in resistance value of the MR layer 11 relative to the wiring resistance and to reduce noise components.

In this embodiment, although the MR layer has a curved and bent shape, Barkhausen noises to be caused by discontinuity of magnetic domains are not generated because isotropic magnetoresistive material such as granular type material is used.

If such a film is formed by using anisotropic magnetoresistive material, changing triangular magnetic domains are formed and move as the magnetic field changes. Therefore, Barkhausen noises are generated by discontinuity of magnetic domains. Since the MR layer is bent, a current path is also bent and the operation of the MR head is adversely affected. Such phenomena can be avoided by using isotropic magnetoresistive material. The MR layer may take other shapes than the V-shape shown in Fig.9A. In order to narrow the track width, it is preferable to take a tapered shape converging toward the front end of the MR head.

Fig.10A is a schematic plan view of a magneto-resistance thin film magnetic head according to another embodiment of the invention, and Fig.10B is a schematic plan view of the MR layer of the magnetic head as viewed in a plane defined by an axis along the width direction and an axis along the height direction. In this embodiment, the MR layer 13 has a bent shape of L-character. The regions of the MR layer 13 where the lead electrodes 14a and 14b ride constitute the above-described passive regions, and the region where they do not ride constitutes the active region.

The MR film 13 has a projected region 13a which extends from the front end portion of the head to a direction parallel to the plane of the head front end. This projected region 13a (horizontal portion of L) has no buffer area reducing demagnetizing field (back region) at the upper portion thereof and does not substantially contribute to reducing demagnetization field. Therefore, the element width W is defined by the vertical portion of L. The MR layer 13 is made of isotropic magnetoresistive material. The lead electrodes 14a and 14b are connected to the projected region and the upper end portion of the MR layer 13. Fig.10C illustrates the connection state between the projected region and the lead electrode 14a. A rectangular active region is therefore formed. The element width W of the MR layer 13 is set smaller than the element height H (H > W). Also in this embodiment, similar advantageous effects of the already described embodiments are obtained.

Also in this embodiment, the active region faces a recording medium and a larger reproduction output can be obtained than the prior art shown in Fig.14 in which a passive region is formed between the active region and the recording medium.

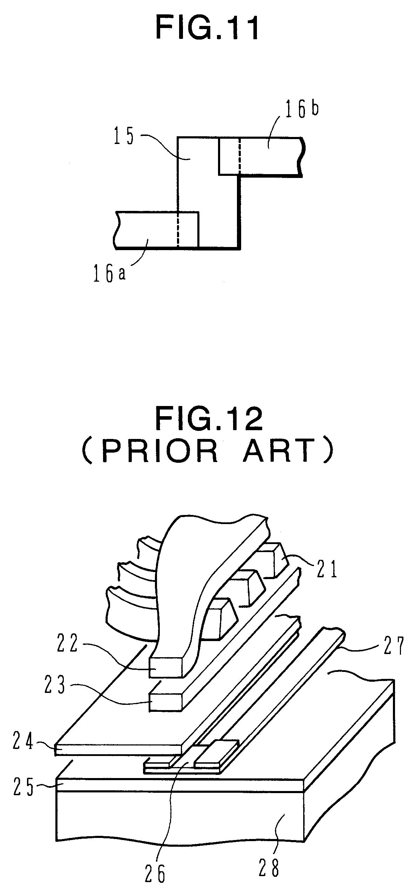

Fig.11 is a schematic plan view of a magneto-resistance thin film magnetic head as viewed in a plane defined by an axis along the width direction and an axis along the height direction, according to another embodiment of the invention. In this embodiment, an MR layer 15 is formed in a rectangle shape whose longer side is in a direction perpendicular to the plane of the head front end, i.e. substantially perpendicular to a surface of the recording medium. Lead electrodes 16a and 16b cover only parts of the rectangular layer 15 in the width direction at the lower and the upper end portions, and so the active region has a crank shape. The MR layer 15 is made of isotropic magnetoresistive material. Also in this embodiment, similar advantageous effects of the already described embodiments are obtained.

The length of an active region of an MR film, the active region contributing to produce changes in output, can be increased by forming the shape of the MR film in a plane defined by the surface of the MR film to have a bent shape such as an L-shape, V-shape, and a curved shape. With such a shape, the resistance value of an MR film increases and a ratio of a magnetoresistance change to a wiring resistance can be made large, so that noise components can be substantially reduced.

As described above, an MR film is made of isotropic magnetoresistive material and at least part of an end portion of the MR film on the head front end side is not covered with the pair of the lead electrodes. Accordingly, it is possible to obtain a magnetoresistance thin film magnetic head having a small demagnetization field, a high magnetic field sensitivity, and a large output.

The present invention has been described in connection with the preferred embodiments. The invention is not limited only to the above embodiments. It is apparent to those skilled in the art that various modifications, substitutions, combinations and the like can be made without departing from the scope of the appended claims.

It should be noted that the objects and advantages of the invention may be attained by means of any compatible combination(s) particularly pointed out in the items of the following summary of the invention and the appended claims.

**The invention may be summarized as follows:**

1. A magnetic head for measuring a magnetic field through changes of resistance value thereof, comprising:

(a) a magnetoresistive material film structure formed on a plane of a substrate and having a first width along a first direction substantially parallel to a first plane of a magnetic recording medium and parallel to the plane of the substrate, and a second width along a second direction substantially perpendicular to the first plane and parallel to the plane of the substrate, a ratio of the second width to the first width being 0.8 or more; and

(b) current supply means contacting the magnetoresistive material film structure for supplying electric current thereto, wherein at least part of a side of the magnetoresistive material film structure nearest to the magnetic recording medium is not contacted by the current supply means.

2. A magnetic head preferably as defined in 1, wherein the current supplying means comprises a pair of conductive leads connected to said magnetoresistive material film structure along said first direction, each of said leads having a third width along the second direction.

3. A magnetic head preferably as defined in 2, wherein the third width is smaller than the second width.

4. A magnetic head preferably as defined in 1, further comprising:

(c) sensing means for sensing changes of a resistance value of the magnetoresistive material film structure.

5. A magnetic head preferably as defined in 1, wherein the magnetoresistive material film structure comprises isotropic magnetoresistive (IMR) material.

6. A magnetic head preferably as defined in 1, wherein the IMR material comprises a granular type magnetoresistive material.

7. A magnetic head preferably as defined in 6, wherein the granular type magnetoresistive material comprises a combination of a ferromagnetic material and a conductive and non-magnetic material, the ferromagnetic material comprises a material selected from a group consisting of Fe, Co, Fe alloy, Co alloy, and FeCo alloy, and the conductive and non-magnetic material comprises a material selected from a group consisting of Ag, Cu, and AgCu alloy.

8. A magnetic head preferably as defined in 6, wherein the granular type magnetoresistive material has an atomic composition expressed by a following chemical formula:

$$(Co_{1-x}Fe_x)_yAg_{1-y},$$

where a value x is set in a range of $0.45 \leq x \leq 0.55$ and a value of y is set in a range of $0.24 \leq y \leq 0.35$.

9. A magnetic head preferably as defined in 6, wherein the granular type magnetoresistive material has an atomic composition expressed by a following chemical formula:

$$(Co_{1-x}Fe_x)_y(Ag_{1-z}Cu_z)_{1-y},$$

where a value x is set in a range of $0.45 \leq x \leq 0.55$, a value of y is set in a range of $0.24 \leq y \leq 0.35$, and a value of z is set in a range of $z \leq 0.14$.

10. A magnetic head preferably as defined in 5, wherein the magnetoresistive material film structure made by the IMR material is a spin valve type transducer.

11. A magnetic head preferably as defined in 10, wherein the spin valve type transducer comprises:

(a-1) a first ferromagnetic material layer having a rotatable first magnetization;

(a-2) a conductive and non-magnetic material layer formed on the first ferromagnetic layer;

(a-3) a second ferromagnetic material layer having a second magnetization of a second magnetization direction to form a sandwich structure with the first ferromagnetic material layer, interposing the conductive and non-magnetic material layer; and

(a-4) an antiferromagnetic material layer for fixing the second magnetization direction of the second magnetization,

wherein the rotatable first magnetization rotates in response to an applied magnetic field and changes its electrical resistance value in response to the rotation of the rotatable first magnetization.

12. A magnetic head preferably as defined in 5, wherein the IMR material comprises a multi-layered artificial lattice film.

13. A magnetic head preferably as defined in 12, wherein the multi-layered artificial lattice film comprises sixty layers of Cr film and sixty layers of Fe film stacked alternately.

14. A magnetic head preferably as defined in 13, wherein the Cr film has a thickness of about 9 angstroms and the Fe film has a thickness of about 30 angstroms.

15. A magnetic head preferably as defined in 1, wherein the magnetoresistive material film structure has a rectangular shape in a plane defined by a first axis along the first direction and a second axis along the second direction.

16. A magnetic head preferably as defined in 1, wherein the magnetoresistive material film structure has a V-shape in a plane defined by a first axis along the first direction and a second axis along the second direction.

17. A magnetic head preferably as defined in 1, wherein the magnetoresistive material film structure has an L-shape in a plane defined by a first axis along the first direction and a second axis along the second direction.

18. A magnetic head preferably as defined in 1, wherein the magnetoresistive material film structure has an active region having a crank shape in a plane defined by a first axis along the first direction and a second axis along the second direction.

19. A magnetic head formed on a substrate for writing data into a magnetic recording medium and reading data from the medium, comprising:

(a) a writing transducer for writing data into a magnetic recording medium through electromagnetic transducing, having a pole region for generating magnetic fluxes toward the medium and a back region for inducing magnetic fluxes, wherein the pole region has a pole width along a first direction substantially parallel to both a plane of the medium and a plane of the substrate, on which plane of the substrate the writing transducer is disposed; and

(b) a reading transducer for reading data from the medium through resistivity changes in response to a magnetic field, comprising:

(b-1) a magnetoresistive material layer, having an active region having a first width along the first direction therein, a passive region formed adjacent to the active region, the first width being smaller than the pole width, the magnetoresistive material layer having a second width along a second direction substantially perpendicular to the plane of the medium and parallel to the plane of the substrate; and

(b-2) conductive means, formed on the magnetoresistive material layer over a third width along the second direction which is smaller than the second width, for supplying electric current to the magnetoresistive material layer.

20. A magnetic head preferably as defined in 19, further comprises:

(c) sensing means for sensing changes of resistance value of the magnetoresistive material layer.

21. A magnetic head preferably as defined in 19, wherein the magnetoresistive material film structure comprises isotropic magnetoresistive (IMR) material.

22. A magnetic head preferably as defined in 21, wherein the IMR material comprises a granular type magnetoresistive material.

23. A magnetic head preferably as defined in 21, wherein the granular type magnetoresistive material comprises a combination of a ferromagnetic material and a conductive and non-magnetic material, the ferromagnetic material comprises a material selected from a group consisting of Fe, Co, Fe alloy, Co alloy, and FeCo alloy, and the conductive and non-magnetic material comprises a material selected from a group consisting of Ag, Cu, and AgCu alloy.

24. A magnetic head preferably as defined in 23, wherein the granular type magnetoresistive material has an atomic composition expressed by a following chemical formula:

$$(Co_{1-x}Fe_x)_yAg_{1-y},$$

where a value x is set in a range of $0.45 \leq x \leq 0.55$ and a value of y is set in a range of $0.24 \leq y \leq 0.35$.

25. A magnetic head preferably as defined in 23, wherein the granular type magnetoresistive material has an atomic composition expressed by a following chemical formula:

$$(Co_{1-x}Fe_x)_y(Ag_{1-z}Cu_z)_{1-y},$$

where a value x is set in a range of $0.45 \leq x \leq 0.55$, a value of y is set in a range of $0.24 \leq y \leq 0.35$, and a value of z is set in a range of $z \leq 0.14$.

26. A magnetic head preferably as defined in 21, wherein the magnetoresistive material film structure made by the IMR material is a spin valve type transducer.

27. A magnetic head preferably as defined in 26, wherein the spin valve type transducer comprises:

EP 0 675 371 A2

(a-1) a first ferromagnetic material layer having a rotatable first magnetization;

(a-2) a conductive and non-magnetic material layer formed on the first ferromagnetic layer;

(a-3) a second ferromagnetic material layer having a second magnetization of a second magnetization direction to form a sandwich structure with the first ferromagnetic material layer, interposing the conductive and non-magnetic material layer; and

(a-4) an antiferromagnetic material layer for fixing the second magnetization direction of the second magnetization,

wherein the rotatable first magnetization rotates in response to an applied magnetic field and changes its electrical resistance value in response to the rotation of the rotatable first magnetization.

28. A magnetic head preferably as defined in 21, wherein the IMR material comprises a multi-layered artificial lattice film.

29. A magnetic head preferably as defined in 21, wherein the multi-layered artificial lattice film comprises sixty layers of Cr film and sixty layers of Fe film stacked alternately.

30. A magnetic head preferably as defined in 29, wherein the Cr film has a thickness of about 9 angstroms and the Fe film has a thickness of about 30 angstroms.

31. A magnetic head preferably as defined in 19, further comprises a layer of insulating material defining the active and passive regions.

32. A magnetic head preferably as defined in 31, wherein the layer of insulating material comprises a material selected from a group consisting of $Al_2O_3$ and $SiO_2$.

33. A magnetic head preferably as defined in 19, further comprising a magnetic bias layer for determining an operating point of the reading transducer.

34. A magnetic head preferably as defined in 33, wherein the magnetic bias layer comprises a material selected from a group consisting of soft magnetic material and permanent magnetic material.

35. A magnetic head preferably as defined in 19, further comprising a magnetic shield layer for isolating the reading transducer from the writing transducer.

36. A magnetic head preferably as defined in 19, wherein the substrate comprises a material selected from a group consisting of glass, ceramics, and semiconductor.

37. A magnetic head preferably as defined in 36, wherein the ceramics comprises $Al_2O_3$-TiC.

38. A magnetic head preferably as defined in 19, wherein the magnetoresistive material film structure has a rectangular shape in a plane defined by a first axis along the first direction and a second axis along the second direction.

39. A magnetic head preferably as defined in 19, wherein the writing transducer comprises a conductive coil for electrically inducing a magnetic flux, an upper magnetic layer and a lower magnetic layer magnetically separated by a gap layer and magnetically connected by a back gap closure.

40. A magnetic head for writing data into a magnetic recording medium and reading data from the medium, comprising:

(a) a writing transducer for writing data into a magnetic recording medium through electro-magnetic transducing, having a pole region for generating magnetic fluxes toward the medium and a back region for inducing magnetic fluxes, wherein the pole region extends along a direction substantially perpendicular to a plane of the medium; and

(b) a reading transducer for reading data from the medium through resistivity changes in response to a magnetic field, comprising:

(b-1) a magnetoresistive material film, having a first width along a first direction parallel to both a plane of the medium and a plane of a substrate, on which plane the magnetoresistive material film is disposed, and a second width along a second direction substantially perpendicular to both a direction of motion of the medium and a plane of the medium, a ratio of the second width to the first width being 0.8 or more, and

(b-2) current supplying means for supplying electric current to the magnetoresistive material film.

41. A magnetic head preferably as defined in 40, wherein the current supplying means comprises a pair of conductive leads connected to said magnetoresistive material film along said first direction, each of said leads having a third width along the second direction.

42. A magnetic head preferably as defined in 41, wherein the third width is smaller than the second width.

43. A magnetic head preferably as defined in 40, further comprises:

(c) sensing means for sensing changes of resistance value of the magnetoresistive material film.

44. A magnetic head preferably as defined in 40, wherein the magnetoresistive material film comprises isotropic magnetoresistive (IMR) material.

12

45. A magnetic head preferably as defined in 44, wherein the IMR material comprises a granular type magnetoresistive material.

46. A magnetic head preferably as defined in 45, wherein the granular type magnetoresistive material comprises a combination of a ferromagnetic material and a conductive and non-magnetic material, the ferromagnetic material comprises a material selected from a group consisting of Fe, Co, Fe alloy, Co alloy, and FeCo alloy, and the conductive and non-magnetic material comprises a material selected from a group consisting of Ag, Cu, and AgCu alloy.

47. A magnetic head preferably as defined in 40, wherein the magnetoresistive material film has a rectangular shape in a plane defined by a first axis along the first direction and a second axis along the second direction.

48. A magnetic head preferably as defined in 40, wherein the magnetoresistive material film comprises isotropic magnetoresistive (IMR) material.

49. A magnetic head preferably as defined in 48, wherein the IMR material comprises a spin valve type transducer.

50. A magnetic head preferably as defined in 49, wherein the spin valve type transducer comprises:

(a-1) a first ferromagnetic material layer having a rotatable first magnetization;

(a-2) a conductive and non-magnetic material layer formed on the first ferromagnetic layer:

(a-3) a second ferromagnetic material layer having a second magnetization of a second magnetization direction to form a sandwich structure with the first ferromagnetic material layer, interposing the conductive and non-magnetic material layer; and

(a-4) an antiferromagnetic material layer for fixing the second magnetization direction of the second magnetization,

wherein the rotatable first magnetization rotates in response to an applied magnetic field and changes its electrical resistance value in response to the rotation of the rotatable first magnetization.

51. A magnetic head preferably as defined in 48, wherein the IMR material comprises a multi-layered artificial lattice film.

52. A magnetic head for measuring a magnetic field, comprising:

(a) a magnetoresistive transducer for measuring a magnetic field through changes in its resistance value, having a first width along a first direction substantially parallel to a plane of a magnetic recording medium and a plane of a substrate, on which plane the magnetoresistive transducer is disposed, and a second width along a second direction substantially perpendicular to the plane of the medium;

(b) a bias film for determining an operating point of the magnetoresistive transducer, the bias film being formed adjacent to the magnetoresistive transducer along the second direction and on an opposite side to the medium; and

(c) current supplying means for supplying electric current to the magnetoresistive transducer.

53. A magnetic head preferably as defined in 52, wherein the bias film comprises a soft magnetic material or a permanent magnetic material.

54. A magnetic head preferably as defined in 52, wherein the current supplying means comprises a pair of conductive leads connected to said magnetoresistive material film along said first direction, each of said leads having a third width along the second direction.

55. A magnetic head preferably as defined in 54, wherein the third width is smaller than the second width.

56. A magnetic head preferably as defined in 52, further comprises:

(d) sensing means for sensing changes of resistance value of the magnetoresistive transducer.

57. A magnetic head preferably as defined in 52, wherein the magnetoresistive transducer comprises isotropic magnetoresistive (IMR) material.

58. A magnetic head preferably as defined in 57, wherein the IMR material comprises a granular type magnetoresistive material.

59. A magnetic head formed on a substrate for writing data into a magnetic recording medium and reading data from the medium, comprising:

(a) a writing transducer for writing data into a magnetic recording medium through electro-magnetic transducing. having a pole region for generating magnetic fluxes toward the medium and a back region for inducing magnetic fluxes, wherein the pole region has a pole width along a first direction substantially parallel to both a plane of the medium and a plane of the substrate, on which plane of the substrate the writing transducer is disposed; and

(b) a reading transducer for reading data from the medium through resistivity changes in response to a magnetic field, comprising:

13

(b-1) a magnetoresistive material layer, having an active region having a first width along the first direction therein, a passive region formed adjacent to the active region, the first width being smaller than the pole width, the magnetoresistive material layer having a second width along a second direction substantially perpendicular to the plane of the medium and parallel to the plane of the substrate; and

(b-2) conductive means formed on the magnetoresistive material layer for supplying electric current to the magnetoresistive material layer.

60. Magnetoresistive thin film magnetic head including:

a magnetoresistive film element made of isotropic magnetoresistive material and having a ratio (H/W) of an element height (H) to an element width (W) set to 0.8 or more; and

a pair of lead electrodes connected to the magnetoresistive film element and having a length ($W_E$) in the element height direction smaller than element height (H) ($W_E$ < H);

wherein part of an end portion of the magnetoresistive film element on the head front end side designed to face to a magnetic recording medium is not covered with the pair of the lead electrodes.

## Claims

1. A magnetic head for measuring a magnetic field through changes of resistance value thereof, comprising:

(a) a magnetoresistive material film structure formed on a plane of a substrate and having a first width along a first direction substantially parallel to a first plane of a magnetic recording medium and parallel to the plane of the substrate, and a second width along a second direction substantially perpendicular to the first plane and parallel to the plane of the substrate, a ratio of the second width to the first width being 0.8 or more; and

(b) current supply means contacting the magnetoresistive material film structure for supplying electric current thereto, wherein at least part of a side of the magnetoresistive material film structure nearest to the magnetic recording medium is not contacted by the current supply means.

2. A magnetic head according to claim 1, wherein the current supplying means comprises a pair of conductive leads connected to said magnetoresistive material film structure along said first direction, each of said leads having a third width along the second direction,

wherein preferably the third width is smaller than the second width,

further preferably comprising:

(c) sensing means for sensing changes of a resistance value of the magnetoresistive material film structure,

wherein preferably the magnetoresistive material film structure comprises isotropic magnetoresistive (IMR) material,

wherein preferably the IMR material comprises a granular type magnetoresistive material,

wherein preferably the granular type magnetoresistive material comprises a combination of a ferromagnetic material and a conductive and non-magnetic material, the ferromagnetic material comprises a material selected from a group consisting of Fe, Co, Fe alloy, Co alloy, and FeCo alloy, and the conductive and non-magnetic material comprises a material selected from a group consisting of Ag, Cu, and AgCu alloy,

wherein preferably the granular type magnetoresistive material has an atomic composition expressed by a following chemical formula:

$$(Co_{1-x}Fe_x)_yAg_{1-y},$$

where a value x is set in a range of $0.45 \leq x \leq 0.55$ and a value of y is set in a range of $0.24 \leq y \leq 0.35$,

wherein preferably the granular type magnetoresistive material has an atomic composition expressed by a following chemical formula:

$$(Co_{1-x}Fe_x)_y(Ag_{1-z}Cu_z)_{1-y},$$

where a value x is set in a range of $0.45 \leq x \leq 0.55$, a value of y is set in a range of $0.24 \leq y \leq 0.35$, and a value of z is set in a range of $z \leq 0.14$,

wherein preferably the magnetoresistive material film structure made by the IMR material is a spin

EP 0 675 371 A2

valve type transducer,

wherein preferably the spin valve type transducer comprises:

(a-1) a first ferromagnetic material layer having a rotatable first magnetization;

(a-2) a conductive and non-magnetic material layer formed on the first ferromagnetic layer;

(a-3) a second ferromagnetic material layer having a second magnetization of a second magnetization direction to form a sandwich structure with the first ferromagnetic material layer, interposing the conductive and non-magnetic material layer; and

(a-4) an antiferromagnetic material layer for fixing the second magnetization direction of the second magnetization,

wherein the rotatable first magnetization rotates in response to an applied magnetic field and changes its electrical resistance value in response to the rotation of the rotatable first magnetization,

wherein preferably the IMR material comprises a multi-layered artificial lattice film,

wherein preferably the multi-layered artificial lattice film comprises sixty layers of Cr film and sixty layers of Fe film stacked alternately,

wherein preferably the Cr film has a thickness of about 9 angstroms and the Fe film has a thickness of about 30 angstroms,

wherein preferably the magnetoresistive material film structure has a rectangular shape in a plane defined by a first axis along the first direction and a second axis along the second direction,

wherein preferably the magnetoresistive material film structure has a V-shape in a plane defined by a first axis along the first direction and a second axis along the second direction,

wherein preferably the magnetoresistive material film structure has an L-shape in a plane defined by a first axis along the first direction and a second axis along the second direction, and

wherein preferably the magnetoresistive material film structure has an active region having a crank shape in a plane defined by a first axis along the first direction and a second axis along the second direction.

3. A magnetic head formed on a substrate for writing data into a magnetic recording medium and reading data from the medium, comprising:

(a) a writing transducer for writing data into a magnetic recording medium through electro-magnetic transducing, having a pole region for generating magnetic fluxes toward the medium and a back region for inducing magnetic fluxes, wherein the pole region has a pole width along a first direction substantially parallel to both a plane of the medium and a plane of the substrate, on which plane of the substrate the writing transducer is disposed; and

(b) a reading transducer for reading data from the medium through resistivity changes in response to a magnetic field, comprising:

(b-1) a magnetoresistive material layer, having an active region having a first width along the first direction therein, a passive region formed adjacent to the active region, the first width being smaller than the pole width, the magnetoresistive material layer having a second width along a second direction substantially perpendicular to the plane of the medium and parallel to the plane of the substrate; and

(b-2) conductive means, formed on the magnetoresistive material layer over a third width along the second direction which is smaller than the second width, for supplying electric current to the magnetoresistive material layer.

4. A magnetic head according to claim 3, further comprises:

(c) sensing means for sensing changes of resistance value of the magnetoresistive material layer,

wherein preferably the magnetoresistive material film structure comprises isotropic magnetoresistive (IMR) material,

wherein preferably the IMR material comprises a granular type magnetoresistive material,

wherein preferably the granular type magnetoresistive material comprises a combination of a ferromagnetic material and a conductive and non-magnetic material, the ferromagnetic material comprises a material selected from a group consisting of Fe, Co, Fe alloy, Co alloy, and FeCo alloy, and the conductive and non-magnetic material comprises a material selected from a group consisting of Ag, Cu, and AgCu alloy,

wherein preferably the granular type magnetoresistive material has an atomic composition expressed by a following chemical formula:

$(Co_{1-x}Fe_x)_yAg_{1-y}$,

15

where a value x is set in a range of $0.45 \leq x \leq 0.55$ and a value of y is set in a range of $0.24 \leq y \leq 0.35$,

wherein preferably the granular type magnetoresistive material has an atomic composition expressed by a following chemical formula:

$$(Co_{1-x}Fe_x)_y(Ag_{1-z}Cu_z)_{1-y},$$

where a value x is set in a range of $0.45 \leq x \leq 0.55$, a value of y is set in a range of $0.24 \leq y \leq 0.35$, and a value of z is set in a range of $z \leq 0.14$,

wherein preferably the magnetoresistive material film structure made by the IMR material is a spin valve type transducer,

wherein preferably the spin valve type transducer comprises:

(a-1) a first ferromagnetic material layer having a rotatable first magnetization;

(a-2) a conductive and non-magnetic material layer formed on the first ferromagnetic layer;

(a-3) a second ferromagnetic material layer having a second magnetization of a second magnetization direction to form a sandwich structure with the first ferromagnetic material layer, interposing the conductive and non-magnetic material layer; and

(a-4) an antiferromagnetic material layer for fixing the second magnetization direction of the second magnetization,

wherein the rotatable first magnetization rotates in response to an applied magnetic field and changes its electrical resistance value in response to the rotation of the rotatable first magnetization,

wherein preferably the IMR material comprises a multi-layered artificial lattice film,

wherein preferably the multi-layered artificial lattice film comprises sixty layers of Cr film and sixty layers of Fe film stacked alternately,

wherein preferably the Cr film has a thickness of about 9 angstroms and the Fe film has a thickness of about 30 angstroms,

further preferably comprises a layer of insulating material defining the active and passive regions,

wherein preferably the layer of insulating material comprises a material selected from a group consisting of $Al_2O_3$ and $SiO_2$,

further preferably comprising a magnetic bias layer for determining an operating point of the reading transducer,

wherein preferably the magnetic bias layer comprises a material selected from a group consisting of soft magnetic material and permanent magnetic material,

further preferably comprising a magnetic shield layer for isolating the reading transducer from the writing transducer,

wherein preferably the substrate comprises a material selected from a group consisting of glass, ceramics, and semiconductor.

wherein the ceramics comprises $Al_2O_3$-TiC,

wherein preferably the magnetoresistive material film structure has a rectangular shape in a plane defined by a first axis along the first direction and a second axis along the second direction, and

wherein preferably the writing transducer comprises a conductive coil for electrically inducing a magnetic flux, an upper magnetic layer and a lower magnetic layer magnetically separated by a gap layer and magnetically connected by a back gap closure.

5. A magnetic head for writing data into a magnetic recording medium and reading data from the medium, comprising:

(a) a writing transducer for writing data into a magnetic recording medium through electro-magnetic transducing, having a pole region for generating magnetic fluxes toward the medium and a back region for inducing magnetic fluxes, wherein the pole region extends along a direction substantially perpendicular to a plane of the medium; and

(b) a reading transducer for reading data from the medium through resistivity changes in response to a magnetic field, comprising:

(b-1) a magnetoresistive material film, having a first width along a first direction parallel to both a plane of the medium and a plane of a substrate, on which plane the magnetoresistive material film is disposed, and a second width along a second direction substantially perpendicular to both a direction of motion of the medium and a plane of the medium, a ratio of the second width to the first width being 0.8 or more, and

(b-2) current supplying means for supplying electric current to the magnetoresistive material film.

6. A magnetic head according to claim 5, wherein the current supplying means comprises a pair of conductive leads connected to said magnetoresistive material film along said first direction, each of said leads having a third width along the second direction,

wherein preferably the third width is smaller than the second width,

further preferably comprising:

(c) sensing means for sensing changes of resistance value of the magnetoresistive material film,

wherein preferably the magnetoresistive material film comprises isotropic magnetoresistive (IMR) material,

wherein preferably the IMR material comprises a granular type magnetoresistive material,

wherein preferably the granular type magnetoresistive material comprises a combination of a ferromagnetic material and a conductive and non-magnetic material, the ferromagnetic material comprises a material selected from a group consisting of Fe, Co, Fe alloy, Co alloy, and FeCo alloy, and the conductive and non-magnetic material comprises a material selected from a group consisting of Ag, Cu, and AgCu alloy,

wherein preferably the magnetoresistive material film has a rectangular shape in a plane defined by a first axis along the first direction and a second axis along the second direction,

wherein preferably the magnetoresistive material film comprises isotropic magnetoresistive (IMR) material, and

wherein preferably the IMR material comprises a spin valve type transducer.

7. A magnetic head according to claim 49, wherein the spin valve type transducer comprises:

(a-1) a first ferromagnetic material layer having a rotatable first magnetization;

(a-2) a conductive and non-magnetic material layer formed on the first ferromagnetic layer;

(a-3) a second ferromagnetic material layer having a second magnetization of a second magnetization direction to form a sandwich structure with the first ferromagnetic material layer, interposing the conductive and non-magnetic material layer; and

(a-4) an antiferromagnetic material layer for fixing the second magnetization direction of the second magnetization,

wherein the rotatable first magnetization rotates in response to an applied magnetic field and changes its electrical resistance value in response to the rotation of the rotatable first magnetization.

8. A magnetic head according to claim 7, wherein the IMR material comprises a multi-layered artificial lattice film.

9. A magnetic head for measuring a magnetic field, comprising:

(a) a magnetoresistive transducer for measuring a magnetic field through changes in its resistance value, having a first width along a first direction substantially parallel to a plane of a magnetic recording medium and a plane of a substrate, on which plane the magnetoresistive transducer is disposed, and a second width along a second direction substantially perpendicular to the plane of the medium;

(b) a bias film for determining an operating point of the magnetoresistive transducer, the bias film being formed adjacent to the magnetoresistive transducer along the second direction and on an opposite side to the medium; and

(c) current supplying means for supplying electric current to the magnetoresistive transducer.

10. A magnetic head according to claim 9, wherein the bias film comprises a soft magnetic material or a permanent magnetic material,

wherein preferably the current supplying means comprises a pair of conductive leads connected to said magnetoresistive material film along said first direction, each of said leads having a third width along the second direction,

wherein preferably the third width is smaller than the second width, preferably

further comprising:

(d) sensing means for sensing changes of resistance value of the magnetoresistive transducer,

wherein preferably the magnetoresistive transducer comprises isotropic magnetoresistive (IMR) material, and

wherein preferably the IMR material comprises a granular type magnetoresistive material.

**11.** A magnetic head formed on a substrate for writing data into a magnetic recording medium and reading data from the medium, comprising:

(a) a writing transducer for writing data into a magnetic recording medium through electro-magnetic transducing, having a pole region for generating magnetic fluxes toward the medium and a back region for inducing magnetic fluxes, wherein the pole region has a pole width along a first direction substantially parallel to both a plane of the medium and a plane of the substrate, on which plane of the substrate the writing transducer is disposed; and

(b) a reading transducer for reading data from the medium through resistivity changes in response to a magnetic field, comprising:

(b-1) a magnetoresistive material layer, having an active region having a first width along the first direction therein, a passive region formed adjacent to the active region, the first width being smaller than the pole width, the magnetoresistive material layer having a second width along a second direction substantially perpendicular to the plane of the medium and parallel to the plane of the substrate; and

(b-2) conductive means formed on the magnetoresistive material layer for supplying electric current to the magnetoresistive material layer.

**12.** Magnetoresistive thin film magnetic head including:

a magnetoresistive film element made of isotropic magnetoresistive material and having a ratio (H/W) of an element height (H) to an element width (W) set to 0.8 or more; and

a pair of lead electrodes connected to the magnetoresistive film element and having a length ($W_E$) in the element height direction smaller than element height (H) ($W_E < H$);

wherein part of an end portion of the magnetoresistive film element on the head front end side designed to face to a magnetic recording medium is not covered with the pair of the lead electrodes.

**13.** A magnetic head for measuring a magnetic field through changes of resistance value thereof, comprising:

(a) a magnetoresistive material film structure formed on a plane of a substrate and having a first width along a first direction substantially parallel to a first plane of a magnetic recording medium and parallel to the plane of the substrate, and a second width along a second direction substantially perpendicular to the first plane and parallel to the plane of the substrate,

and

(b) current supply means contacting the magnetoresistive material film structure for supplying electric current thereto.

# FIG.1

SENSING
APPARATUS

CURRENT
SOURCE

1 d

B

1

2 a

2 b

MD

8

# FIG.2

8

2 a

2 b

AR

1 a    1 b    1    1 c

# FIG.3

# FIG.4

FIG.5

# FIG.6A

EP 0 675 371 A2

FIG.6B

FIG.6C

# FIG.7

70-1
71-1
70-2
71-2
71-59
70-60
71-60

# FIG.8

84   83   82   81   85

86

FIG. 9A

FIG. 9B

FIG.10A

FIG.10B

FIG.10C

# FIG.11

15
16b
16a

# FIG.12
# (PRIOR ART)

21
22
23
24
25
27
26
28

# FIG.13
# (PRIOR ART)

32a  31  32b

H

33

$T_W$

W

# FIG.14
# (PRIOR ART)

37a

H  36

37b

33

W
($T_W$)